# EUROPEAN PATENT APPLICATION

(11) **EP 1 978 574 A2**
(43) Date of publication of application: **08.10.2008**
(21) Application number: 08006799.4
(22) Date of filing: 03.04.2008
(51) Int. Cl.: H01L 51/50, H01L 51/54

(54) **Organic electroluminescent device**

(30) Priority: 05.04.2007 JP 2007099124
(71) Applicant: Yamagata Promotional Organization for Industrial Technology, Yamagata-shi, Yamagata 990-2473 (JP)
(72) Inventor: Nakai, Toshimitsu, Yokohama-shi Kanagawa 227-8502 (JP); Oda,Atsushi Yamagata Promotional Org. Industrial Technology, Yamagata-shi Yamagata 990-2473 (JP)
(74) Representative: HOFFMANN EITLE

(57) **Abstract**

The present invention provides an organic electroluminescent device that can keep a stable luminescent characteristic for a long period. An organic electroluminescent device includes at least an anode 2, a charge generating layer 3, a luminescent layer 4 and a cathode 5 in this order. The charge generating layer 3 has an area 3a containing an electron transporting material at the anode side, and an area 3b containing a hole transporting material and a material capable of forming a charge transfer complex with the hole transporting material by an oxidation-reduction reaction at the cathode side, the hole transporting material and the material being laminated or mixed. The hole transporting material is in a radical cation state.

## Description

### BACKGROUND OF THE INVENTION

### Field of the Invention

The present invention relates to an increase of service life of an organic electroluminescent (hereinafter, referred to as organic EL) device.

### Description of the Related Art

An organic EL device is a self-emitting type device employing an organic compound as a luminescent material. It can emit light with high speed, so that it is preferable for a display of a moving image. Further, an organic EL device has a characteristic that its device structure is simple, which makes it possible to reduce a thickness of a display panel. Since the organic EL device has excellent characteristics described above, it has been spreading in daily life as used for a mobile phone, or a vehicle-mounted display.

However, the organic EL device has a problem that a driving life is short as compared to an EL device composed of an inorganic material. Examples of a phenomenon that causes an unstable driving of the device include a reduction in luminescent intensity increase in voltage when the device is driven with constant current, generation of non-luminescent portion, i.e., generation of so-called dark spot, etc.

These phenomena are produced by various reasons. Examples of the phenomena among these caused by components of the organic EL device include a deterioration in a shape of a thin film of an organic layer due to crystallization or condensation of an organic amorphous film caused by a heat generation at the time of driving the device, a chemical change caused by the repetition of oxidation and deoxidation accompanied by a charge transportation of a charge transportation material, a deterioration in a luminescent material in a luminescent layer, a deterioration due to water content or oxygen in a trace amount, etc. Examples of the above-described phenomena at the interface of the electrode include an extinction due to a migration of metal ion or the like, which forms the electrode, into the organic layer, contact failure at the interface between the electrode and the organic layer, etc. Further, examples of the foregoing phenomena include deterioration caused by an oxidation or reduction by charges that do not recombine in the luminescent layer and pass therethrough to reach a counter electrode, etc.

When a driving voltage is high, a non-preferable electrochemical reaction is produced in the organic layer, or a charge balance is lost, so that the driving life is likely to decrease. In order to prevent the rise in the driving voltage, it is particularly important to improve the contact between an anode and an organic layer.

Therefore, it has been studied to reduce the driving voltage by providing a hole injecting layer on the anode.

The conditions required to materials used for the hole injecting layer include that the material can form a uniform thin film, the material is thermally stable, the material has low ionization potential, holes can easily be injected from an anode by the material, the material has a large hole mobility, etc. Specific examples of the material include porphylin derivative, phthalocyanine compound, starburst aromatic triamine, sputter/carbon film, metal oxides such as vanadium oxides, ruthenium oxides, and molybdenum oxides, etc.

Japanese Patent Application Laid-Open (JP-A) No. 11-251067 (Patent Document 1) and JP-A No. 2001-244079 (Patent Document 2) disclose a technique of doping an electron-accepting dopant or Lewis acid into a hole injecting layer in order to enhance a hole injecting property from an anode to an organic layer.

JP-A No. 2006-49393 (Patent Document 3) discloses a technique in which a hole injecting layer has a two-layer laminated structure having an electron extracting layer with a deep LUMO (lowest unoccupied molecular orbital) and a hole transporting material layer, and the electron extracting layer extracts electrons from the adjacent hole transporting material layer so as to generate holes in the hole transporting material layer.

JP-A No. 2006-503443 (Patent Document 4) discloses that a hexaazatriphenylene-based compound layer is formed on an anode containing a material whose work function is about 4.5 eV or lower in order to promote the hole transportation.

However, the electron-accepting dopant, Lewis acid, and material for the electron extracting layer disclosed in the above-mentioned Patent Documents 1 to 4 extract electrons from the HOMO (highest occupied molecular orbital) of the adjacent hole transporting material, so that the LUMO level of these materials is deep. These materials have excellent reactivity due to their high electron-accepting property. Accordingly, there are problems such that they are difficult to be handled, a trace amount of them enters the other layer as impurities upon the vapor deposition, they form a trap level to remarkably reduce the performance of the device, and synthesis is not so easy due to the excellent reactivity.

The techniques disclosed in the above-mentioned Patent Documents 1 to 4 form a layer with a material having high electron-accepting property, although these techniques can enhance a hole injecting characteristic. Therefore, these techniques entail a problem in stability of the device, and further, the driving life is insufficient.

A short driving life and low stability of an organic EL device as described above is a significant problem as a light source for a facsimile, copier, backlight of a liquid crystal display, illumination, etc. Further, such organic EL device is undesirable for a display device for a full-color flat panel display, etc.

### SUMMARY OF THE INVENTION

The present invention is accomplished to solve the above-mentioned technical problems, and aims to provide an organic EL device that can maintain a stable luminescent characteristic for a long period.

An organic EL device according to the present invention is an organic electroluminescent device including an anode in this order, a charge generating layer, a luminescent layer, and a cathode, wherein the charge generating layer has an area containing a charge transporting material at the anode side, and has an area containing a hole transporting material and a material that is capable of forming a charge transfer complex by an oxidation-reduction reaction with the hole transporting material, these materials being laminated or mixed, and the hole transporting material is in a radical cation state.

The formation of the specific charge generating layer between the anode and the luminescent layer can considerably increase a driving life.

It is preferable that, in the organic EL device, the area containing the charge transporting material comes in contact with the anode.

It is further preferable that an area containing a charge transporting material is provided between the anode and the charge generating layer, wherein the area containing the charge transporting material preferably comes in contact with the anode.

An organic EL device according to another aspect of the present invention further has at least one set including at least the charge generating layer and the luminescent layer in this order between the luminescent layer and the cathode layer in the organic EL device.

As described above, the present invention is applicable to a multi-photon emission structure having plural sets including the charge generating layer and the luminescent layer.

In this case, it is preferable that at least one layer of the charge generating layers composing the sets has an area containing a charge transporting material at the anode side, and has, at the cathode side, an area containing a hole transporting material and a material that is capable of forming a charge transfer complex by an oxidation-reduction reaction with the hole transporting material, these materials being laminated or mixed, and the hole transporting material is in a radical cation state.

In the organic EL device, it is more preferable that the material capable of forming the charge transfer complex by an oxidation-reduction reaction with the hole transporting material is a metal oxide.

As described above, the present invention can provide a stable organic EL device having long service life in which the luminance is less reduced even if the device is driven for a long time.

Accordingly, the organic EL device according to the present invention is expected to be applied to a flat panel for an OA computer or a flat pane for a wall-mounted television that is the usage requiring a long-term stable illumination; a light source such as a light source for an illumination device or copier, a light source of a backlight for a liquid display or measuring instrument, etc. that utilizes a characteristic of a surface light emitter; a display board; and a beacon light.

### BRIEF DESCRIPTION OF THE DRAWINGS

FIG. 1 is a sectional view schematically showing one example of a structure of an organic EL device according to the present invention;
FIG. 2 is a sectional view schematically showing one example of a structure of an organic EL device according to another aspect of the present invention;
FIG. 3 is a sectional view schematically showing one example of a structure of an organic EL device according to another aspect of the present invention;
FIG. 4 is a sectional view schematically showing one example of a structure of an organic EL device according to another aspect of the present invention;
FIG. 5 is a sectional view schematically showing one example of a structure of an organic EL device according to another aspect of the present invention;
FIG. 6 is a sectional view schematically showing one example of a multi-photon emission structure of an organic EL device according to the present invention;
FIG. 7 is a sectional view schematically showing one example of a multi-photon emission structure (two-stage) of an organic EL device according to the present invention;
FIG. 8 is a sectional view schematically showing one example of a multi-photon emission structure of an organic EL device according to another aspect of the present invention;
FIG. 9 is sectional view schematically showing one example of an area of a charge generating layer containing an electron transporting material in the organic EL device according to the present invention;
FIG. 10 is sectional view schematically showing one example of an area of a charge generating layer containing an electron transporting material in the organic EL device according to another aspect of the present invention;
FIG. 11 is sectional view schematically showing one example of an area of a charge generating layer containing an electron transporting material in the organic EL device according to another aspect of the present invention;
FIG. 12 is sectional view schematically showing one example of an area of a charge generating layer containing an electron transporting material in the organic EL device according to another aspect of the present invention;
FIG. 13 is sectional view schematically showing one example of an area of a charge generating layer containing a hole transporting material in the organic EL device according to the present invention;
FIG. 14 is sectional view schematically showing one example of an area of a charge generating layer containing a hole transporting material in the organic EL device according to another aspect of the present invention; and
FIG. 15 is sectional view schematically showing one example of an area of a charge generating layer containing a hole transporting material in the organic EL device according to another aspect of the present invention.

### DESCRIPTION OF THE PREFERRED ASPECTS

The present invention will be explained in more detail with reference to the drawings.

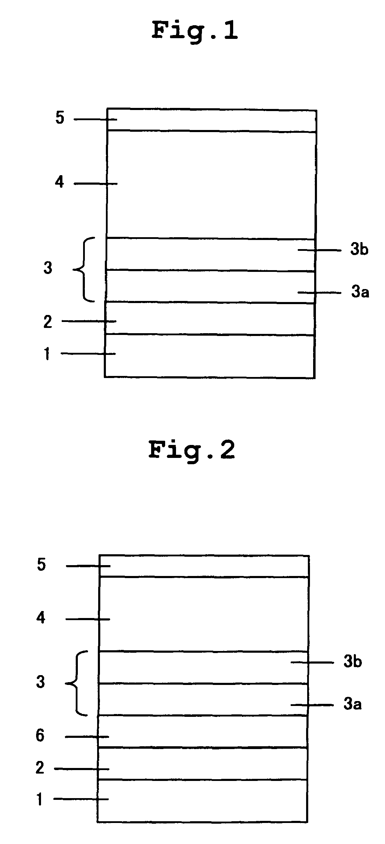

FIG. 1 shows one example of a structure of an organic EL device according to the present invention. The organic EL device shown in FIG. 1 includes an anode 2, a first charge generating layer 3, a first luminescent layer 4, and a cathode 5 in this order on a substrate 1. Specifically, the organic EL device includes one set of the charge generating layer and the luminescent layer.

The first charge generating layer 3 has an area 3a at the anode side containing a first electron transporting material and an area 3b at the cathode side containing a first hole transporting material and a material capable of forming a charge transfer complex by an oxidation-reduction reaction with the first hole transporting material, wherein the first hole transporting material is in a radical cation state.

When the charge generating layer is not present between the anode and the luminescent layer as is conventionally, i.e., when a hole transporting layer or a hole injecting layer is present on the anode, electrons passing to reach the anode without being recombined in the luminescent layer cause degradation in the reduction, by which the organic EL device is susceptible to deterioration, since the hole transporting layer and the hole injecting layer are generally unstable to the reduction.

On the other hand, in the present invention, a specific charge generating layer is formed between the anode and the luminescent layer, whereby a small amount of electrons that cannot be recombined in the luminescent layer to pass through the luminescent layer are smoothly transferred to the anode through the charge generating layer. Further, the charge generating layer has, at its anode side, the area containing the electron transporting material, whereby the charge generating layer is stable for the reduction, with the result that the service life of the organic EL device can be increased.

### (Substrate)

The substrate is a support member of the organic EL device. Usable materials for the substrate include a quartz or glass plate, metal plate, metal foil, plastic film, plastic sheet, etc. Particularly, a glass plate or a plate made of a transparent synthetic resin such as polyester, polymethacrylate, polycarbonate, polysulfone, etc. is preferable.

When a substrate made of a synthetic resin is used, care should be taken to a gas barrier property. When the gas barrier property of the substrate is too small, the organic EL device might be deteriorated due to the open air passing through the substrate. Therefore, as one preferable technique for securing the gas barrier property, a dense silicon oxide film or the like may be provided on at least one surface of the substrate made of synthetic resin.

### (Anode)

The anode formed on the substrate has an function for injecting holes into the first hole transporting material. The anode is ordinarily composed of a metal such as aluminum, gold, silver, nickel, palladium, platinum, etc.; a metal oxide such as an oxide of indium and/or tin; a haloganated metal such as a copper iodide; carbon black, etc.

The anode is ordinarily formed by a sputtering method, vacuum deposition, etc. When metallic fine particles of silver or the like, fine particles of copper iodide or the like, carbon black, conductive fine particles of a metal oxide are employed, they may be dispersed in an appropriate binder resin solution, and the resultant may be applied on the substrate, thereby forming the anode. The anode can further be formed by laminating different materials.

The thickness of the anode depends on the required transparency. When the transparency is required, the transmittance of the visible light is ordinarily set to not less than 60%, and more preferably not less than 80%. The thickness in this case is ordinarily about 5 to 1000 nm, more preferably about 10 to 500 nm.

On the other hand, when the transparency is not so required, the anode may be made of the material same as that of the substrate. Further, a different conductive material can be laminated on the anode.

### (First charge generating layer)

The first charge generating layer formed on the anode has the area at the anode side containing the first electron transporting material and the area at the cathode side containing the first hole transporting material and the material capable of forming the charge transfer complex by the oxidation-reduction reaction with the first hole transporting material, these materials being laminated or mixed, wherein the first hole transporting material is in a radical cation state.

The hole current - electron-current conversion layer disclosed in JP-A No. 2005-166637 and formed in order to reduce damage upon forming a contact layer or a cathode can be applied to the charge generating layer described above, for example.

The thickness of the first charge generating layer is ordinarily 1 nm or larger and 200 nm or smaller, preferably 5 nm or larger and 100 nm or smaller.

It is preferable that the first charge generating layer comes in contact with the anode.

### (Area containing first electron transporting material)

The area of the first charge generating layer at the anode side contains the first electron transporting material. The first electron transporting material should be a compound having a large electron affinity, being stable to a reduction, having a large electron mobility, and being difficult to produce impurities that become a trap at the time of the manufacture or use. Therefore, the material that is conventionally used in the organic EL device for transporting the electrons, injected from the cathode, can be used.

Specific preferable examples include oxadiazole derivative, oxazole derivative, thiazole derivative, thiaziazole derivative, pyrazine derivative, triazole derivative, triazine derivative, perylene derivative, quinoline derivative, quinoxaline derivative, fluorenone derivative, anthrone derivative, phenanthroline derivative, organic metal complex, pyridine derivative, pyrrolopyridine derivative, pyrimidine derivative, naphthyridine derivative, silol derivative, etc. More preferable examples among these are oxadiazole derivative, quinoline derivative, organic metal complex, phenanthroline derivative, pyridine derivative, pyrrolopyridine derivative, pyrimidine derivative, and naphthyridine derivative.

Preferable compound groups are represented by (Chemical formula 1) to (Chemical formula 6) described below, but the first electron transporting material according to the present invention is not limited thereto. The compounds selected from the group represented by the (Chemical formula 1) are particularly preferable.

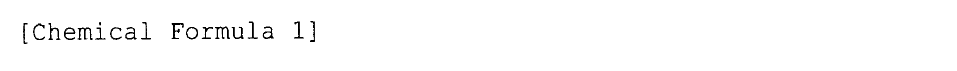

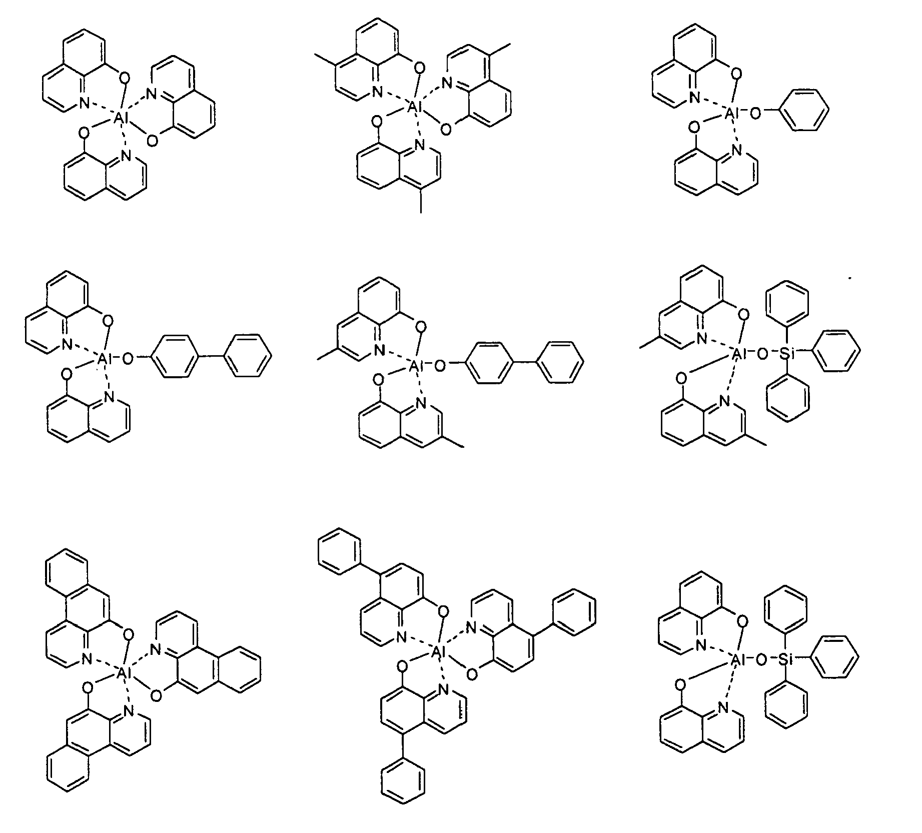

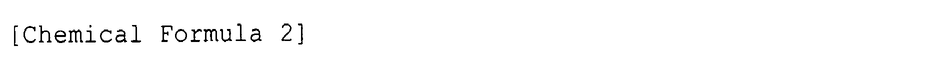

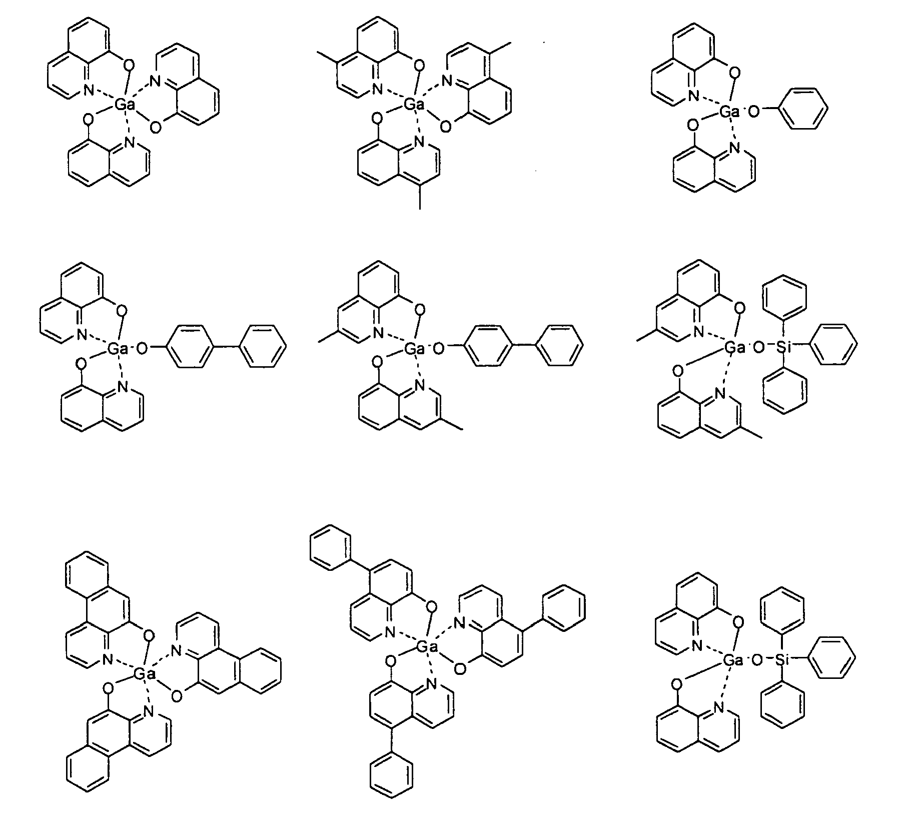

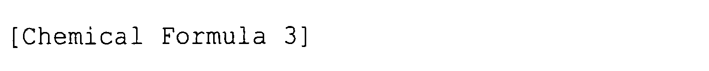

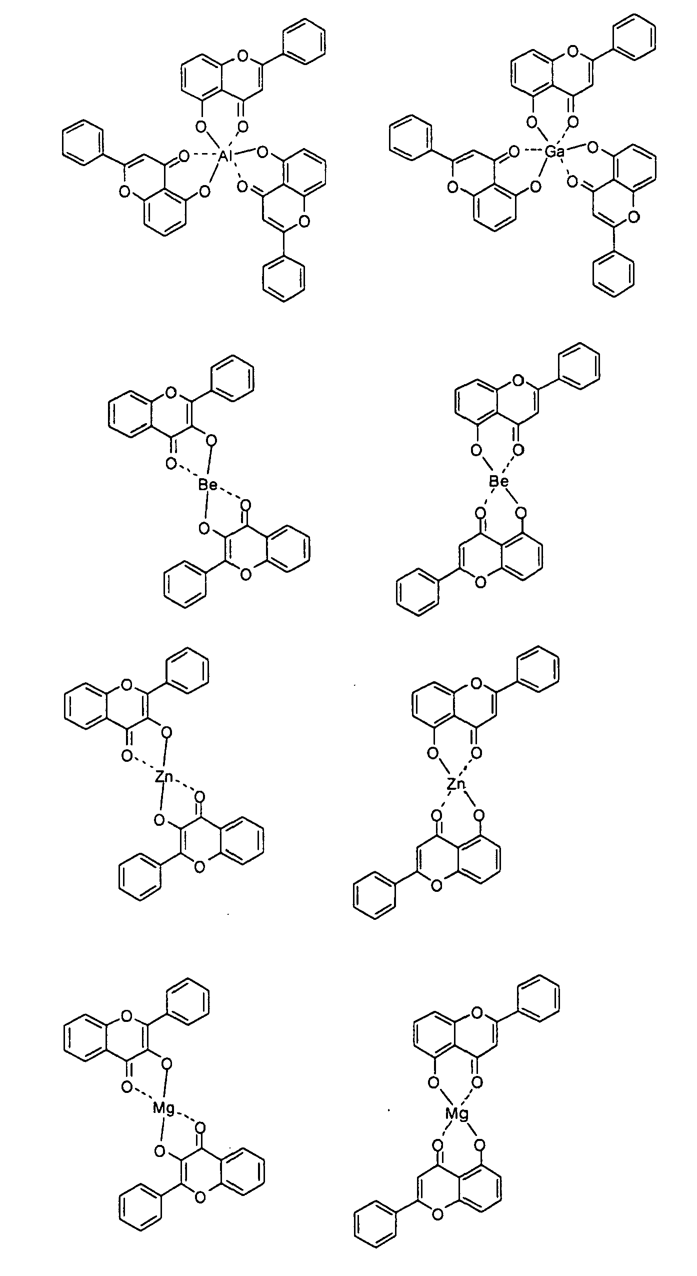

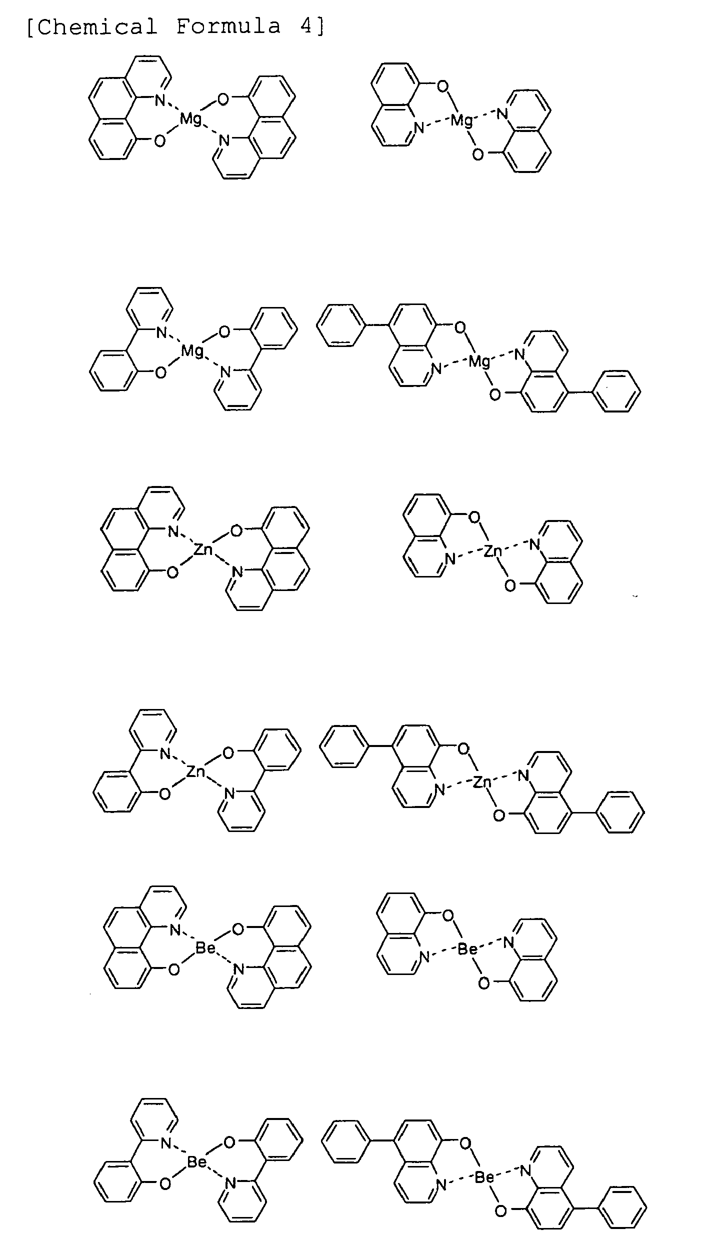

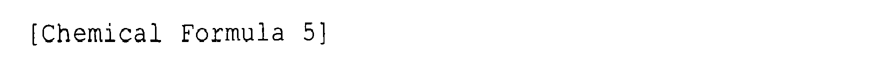

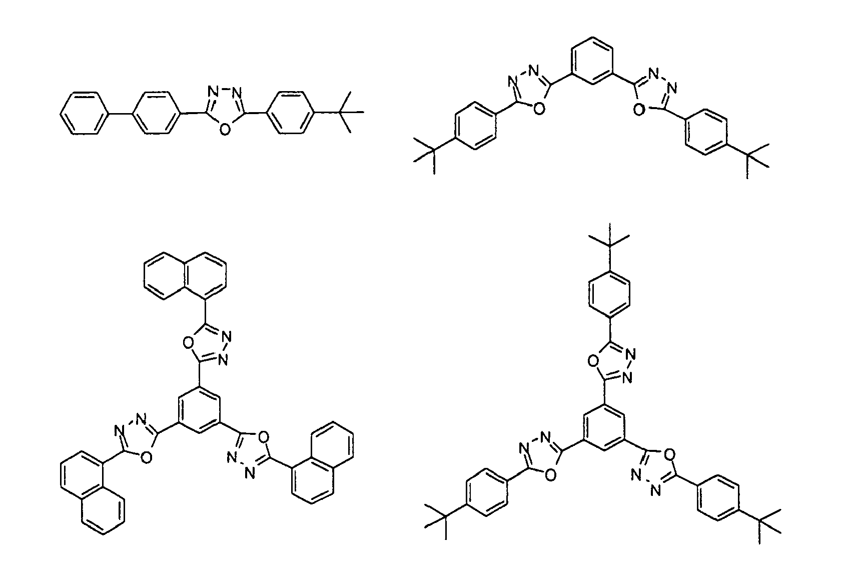

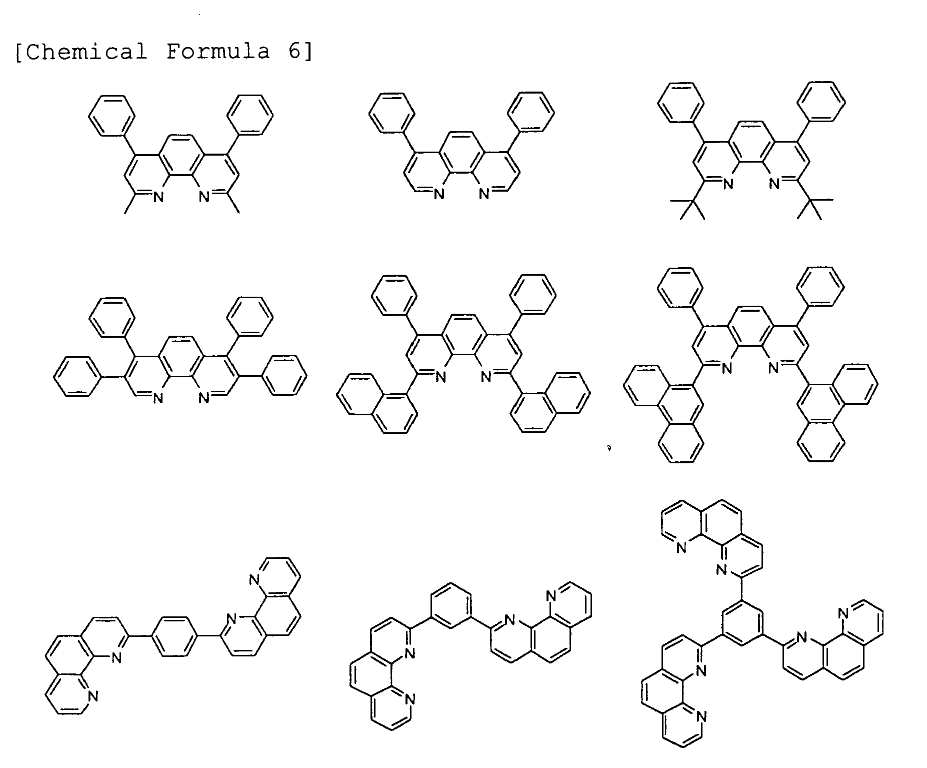

The area containing the first electron transporting material may contain one kind of these materials having electron-transporting property as the first electron transporting material. Alternatively, the area containing the first electron transporting material may contain two or more kinds of the materials.

The area containing the first electron transporting material may include a laminated body or a co-deposited mixture layer of an organic metal complex compound (hereinafter, abbreviated as "organic metal complex compound containing a metal ion with a low work function"), which is represented by an alkali metal ion, alkaline-earth metal ion, rare-earth metal ion, and some transition metal ions and contains a metal ion with a low work function of not more than 4.0 eV, disclosed in the JP-A No. 2005-166637, and a thermally reducible metal (hereinafter, abbreviated as "thermally reducible metal") that can reduce a metal ion in the organic metal complex compound into a metal in a vacuum.

The organic metal complex compound containing the metal ion with a low work function is not particularly limited. Examples of the compound include mono (8-quinolinolate) lithium complex (hereinafter abbreviated as Liq) represented by the (Chemical formula 7) described below.

It is preferable that any one of aluminum, silicon, zirconium, titanium and tungsten is contained as the thermally reducible metal.

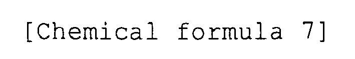

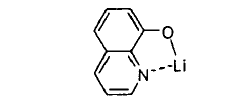

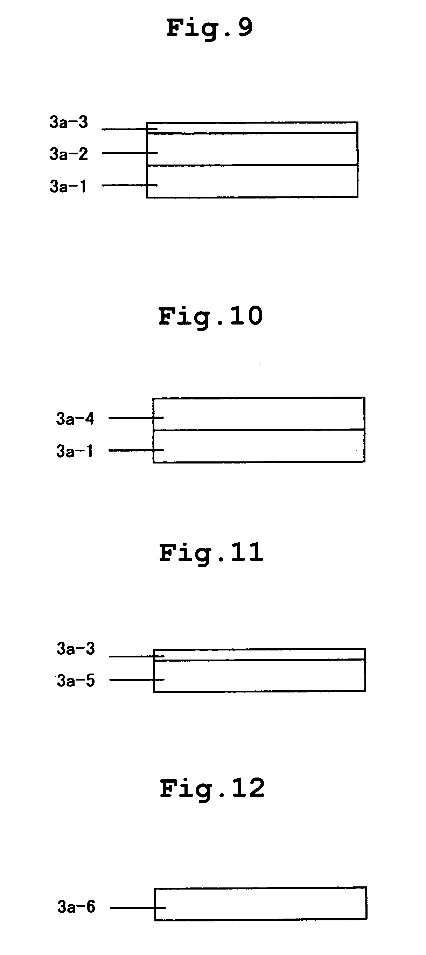

Specifically, the area containing the first electron transporting material is a laminated member or a mixture layer shown in FIGS. 9 to 12.

The area 3a containing the first electron transporting material shown in FIG. 9 is a laminated body having a layer 3a-1 containing the first electron transporting material (A), a layer 3a-2 containing the organic metal complex compound (B) containing a metal ion with a low work function, and a thermally reducible metal (C) 3a-3 formed in this order.

The area 3a containing the first electron transporting material shown in FIG. 10 is a laminated body having a layer 3a-1 containing the first electron transporting material (A), and a mixture layer 3a-4 containing the organic metal complex compound containing a metal ion with a low work function and the thermally reducible metal (B + C) formed in this order.

The area 3a containing the first electron transporting material shown in FIG. 11 is a laminated body having a mixture layer 3a-5 containing the first electron transporting material and the organic metal complex compound containing a metal ion with a low work function (A + B), and the thermally reducible metal (C) 3a-3 formed in this order.

The area 3a containing the first electron-transporting material shown in FIG. 12 is a mixture layer containing the first electron transporting material, the organic metal complex compound containing a metal ion with a low work function, and the thermally reducible metal (A + B + C).

In FIGS. 9 to 12, the thermally reducible metal 3a-3, which is considered to be not present as a layer actually, is illustrated as a layer for the sake of convenience. It is not necessary that the interface is always clearly present in each layer shown in FIGS. 9 to 12, although each layer is illustrated as the laminated body. The upper layer and the lower layer may be mixed in the vicinity of the interface. Alternatively, the material may continuously change from the lower layer to the upper layer with a concentration gradient.

The thickness of the area 3a containing the first electron transporting material is ordinarily 0.1 nm or larger and 100 nm or smaller, preferably 1 nm or larger and 50 nm or smaller.

When the area 3a containing the first electron transporting material is formed by laminating, on the layer 3a-1 containing the first electron transporting material (A), the layer 3a-2 containing the organic metal complex compound (B) containing a metal ion with a low work function or the mixture layer 3a-4 containing the organic metal complex compound containing a metal ion with a low work function and the thermally reducible metal (B + C) as shown in FIGS. 9 and 10, the thickness of the area 3a-1 containing the first electron transporting material (A) is ordinarily 1 nm or larger and 100 nm or smaller, preferably 2 nm or larger and 50 nm or smaller.

The thickness of the layer 3a-2 containing the organic metal complex compound (B) containing a metal ion with a low work function or the mixture layer 3a-4 containing the organic metal complex compound containing a metal ion with a low work function and the thermally reducible metal (B + C) is ordinarily 0.1 nm or larger and 100 nm or smaller, preferably 1 nm or larger and 50 nm or smaller.

The thermally reducible metal (C) 33 is not present as the metal layer as disclosed in JP-A No. 2005-123094 and JP-A No. 2005-166637. Therefore, when the thermally reducible metal (C) 33 is laminated on the layer 3a-2 containing the organic metal complex compound (B) containing a metal ion with a low work function as shown in FIG. 9, the deposition thickness is preferably 1 nm or larger and 2 nm or smaller, if the thermally reducible metal is aluminum. When the thermally reducible metal is mixed with the organic metal complex compound (B) containing a metal ion with a low work function as shown in FIG. 10, the molar ratio is preferably within the range of 1 : 10 to 10 : 1 that is the range not spoiling transparency, i.e., the range that is practically free from trouble with respect to the light transmittance emitted from the luminescent layer. (Area in which first hole transporting material and a material capable of forming a charge transfer complex with the first hole transporting material by oxidation-reduction reaction are laminated or mixed)

The first hole transporting material, which is contained in the area 3b that is formed by laminating or mixing the first hole transporting material and the material capable of forming the charge transfer complex with the first hole transporting material by the oxidation-reduction reaction, the first hole transporting material being in a radical cation state (hereinafter referred to as "area containing the first hole-transporting material"), needs to be stable for the oxidation, to have high hole mobility, to be excellent in stability, and to be difficult to generate impurities that causes a trap during the manufacture or usage. Known materials conventionally used for the organic EL device can be employed for the first hole transporting material.

The first hole transporting material is oxidized by the oxidation-reduction reaction by an electron transfer between the first hole transporting material and the material capable of forming the charge transfer complex, thereby being in a radical cation state.

Examples of the hole transporting material include an aromatic amine compound, and the aromatic amine compound represented by the Chemical Formula 8 is preferable. 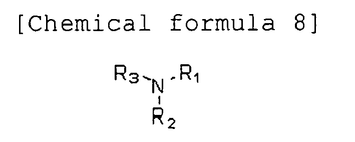 (Wherein R1, R2, and R3 each represents an aromatic hydrocarbon group independently having a substituent.)

The above-mentioned aromatic amine compound is not particularly limited, but the preferable aromatic amine compounds are those disclosed in JP-A No. 6-25659, JP-A No. 6-203963, JP-ANo. 6-215874, JP-ANo. 7-145116, JP-ANo. 7-224012, JP-A No. 7-157473, JP-A No. 8-48656, JP-A No. 7-126226, JP-A No. 7-188130, JP-ANo. 8-40995, JP-ANo. 8-40996, JP-ANo. 8-40997, JP-A No. 7-126225, JP-A No. 7-101911, and JP-A No. 7-97355. Specific examples include N,N,N',N'-tetraphenyl-4,4'-diaminophenyl, N,N'-diphenyl-N,N'-di(3-methylphenyl)-4,4'-diaminobiphenyl, 2,2-bis(4-di-p-tolylaminophenyl) propane, N,N,N',N'-tetra-p-tolyl-4,4'-diaminobiphenyl, bis(4-di-p-tolylaminophenyl) phenylmethane, N,N'-diphenyl-N,N'-di(4-methoxyphenyl)-4,4'-diaminobiphenyl, N,N,N',N'-tetraphenyl-4,4'-diaminodiphenyl ether, 4,4'-bis(diphenylamino) quadriphenyl, 4-N,N-diphenylamino-(2-diphenylvinyl) benzene, 3-methoxy-4'-N,N-diphenylamino stilbenzene, N-phenylcarbazole, 1,1-bis(4-di-p-triaminophenyl)-cyclohexane, 1,1-bis(4-di-p-triaminophenyl)-4-phenylcyclohexane, bis(4-dimethylamino-2-methylphenyl)-phenylmethane, N,N,N-tri(p-tolyl)amine, 4-(di-p-tolylamino)-4'-[4(di-p-tolylamino) styryl] stilbene, N,N,N',N'-tetraphenyl-4,4'-diamino-biphenylN-phenylcarbazol e, 4,4'-bis[N-(1-naphthyl)-N-phenylamino]biphenyl, 4,4'-bis[N-(1-naphthyl)-N-phenylamino]p-terphenyl, 4,4'-bis[N-(3-acenaphthenyl)-N-phenyl-amino]biphenyl, 1,5-bis[N-(1-naphthyl)-N-phenyl-amino] naphthalene, 4,4'-bis[N-(9-anthryl)-N-phenyl-amino] biphenyl, 4,4"-bis[N-(1-anthryl)-N-phenyl-amino]p-terphenyl, 4,4'-bis[N-(2-phenanthryl)-N-phenyl-amino] biphenyl, 4,4'-bis[N-(8-fluoranthenyl)-N-phenyl-amino] biphenyl, 4,4'-bis[N-(2-pyrenyl)-N-phenyl-amino] biphenyl, 4,4'-bis[N-(2-perylenyl)-N-phenyl-amino] biphenyl, 4,4'-bis[N-(1-coronenyl)-N-phenyl-amino] biphenyl, 2,6-bis(di-p-tolylamino) naphthalene, 2,6-bis[di-(1-naphthyl) amino] naphthalene, 2,6-bis[N-(1-naphthyl)-N-(2-naphthyl) amino] naphthalene, 4,4"-bis[N,N-di(2-naphthyl) amino] terphenyl, 4,4'-bis[N-phenyl-N-[4-(1-naphthyl) phenyl] amino} biphenyl, 4,4'-bis[N-phenyl-N-(2-pyrenyl)-amino] biphenyl, 2,6-bis[N,N-di(2-naphthyl) amino] fluorine, 4,4"-bis(N,N-di-p-tolylamino) terphenyl, bis(N-1-naphthyl) (N-2-naphthyl) amine, 4,4'-bis[N-(2-naphthyl)-N-phenyl-amino] biphenyl (α-NPD) represented by the (Chemical Formula 9) described below, 4,4'-bis[N-(9-phenantolyl)-N-phenyl-amino] biphenyl (PPD) represented by the (Chemical Formula 10) described below, spiro-NPB represented by the (Chemical Formula 11) described below, spiro-TAD represented by the (Chemical Formula 12) described below, 2-TNATA represented by the (Chemical Formula 13) described below, etc.

Among these aromatic amine compounds, those having a glass transition point of not less than 90°C are more preferable from the viewpoint of heat resistance of the device. Particularly, α-NPD, PPD, (spiro-)NPB, (spiro-)TAD, and 2-TNATA are preferable.

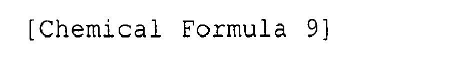

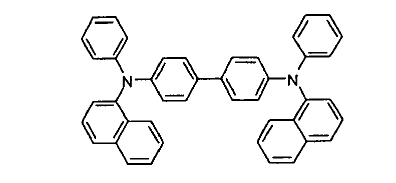

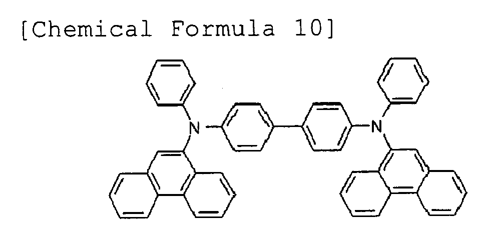

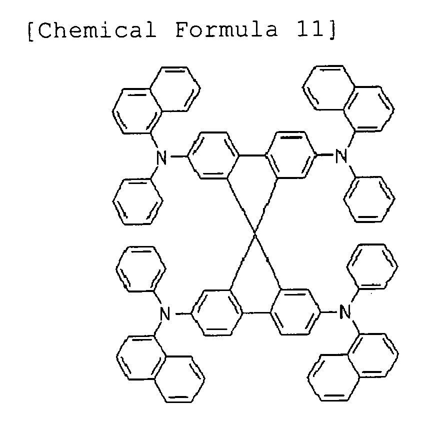

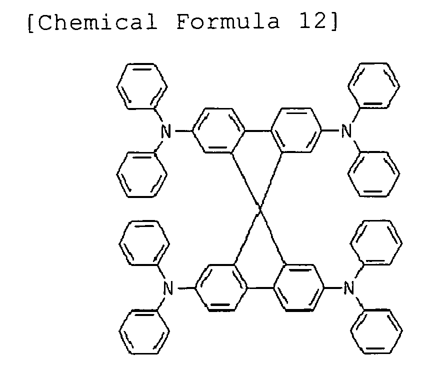

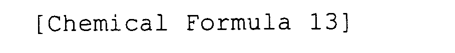

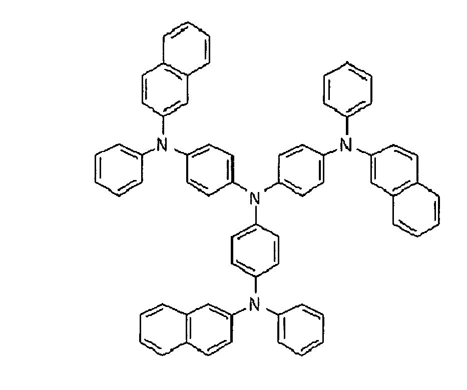

The hole transporting material may be porphylin compound, phthalocyanine compound, quinacridone compound, or indanthrene compound, or derivatives thereof.

Known materials conventionally used for an organic EL device can appropriately be used for the hole transporting material.

The area containing the first hole transporting material may contain one kind of these hole transporting materials or two or more kinds of these hole transporting materials.

Thematerial capable of forming the charge transfer complex with the hole transporting material by the oxidation-reduction reaction may be an inorganic material or organic material.

Examples of the organic material include iron halides such as ferric chloride, ferric bromide, etc.; metallic halides such as aluminum halide, gallium halide, indium halide, antimony halide or arsenic halide, or metal oxides such as vanadium pentoxide (V₂O₅), molybdenum trioxide (MoO₃), rhenium heptoxide (Re₂O₇, tungsten trioxide (WO₃), etc. (see JP-A No. 2005-16637) .

On the other hand, as the organic material, a compound having fluorine as a substituent, or a compound having a cyano group as a substituent is preferable. Particularly, a compound having a fluorine and cyano group as a substituent such as tetrafluoro-tetracyanoquinodimethane (F4-TCNQ) or the like represented by the (Chemical Formula 14) described below is more preferable. Further, a compound having a boron atom is preferable, and a compound having a fluorine substituent and a boron atom represented by the following (Chemical Formula 15) is more preferable (see JP-A No. 2005-16637).

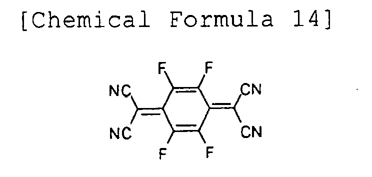

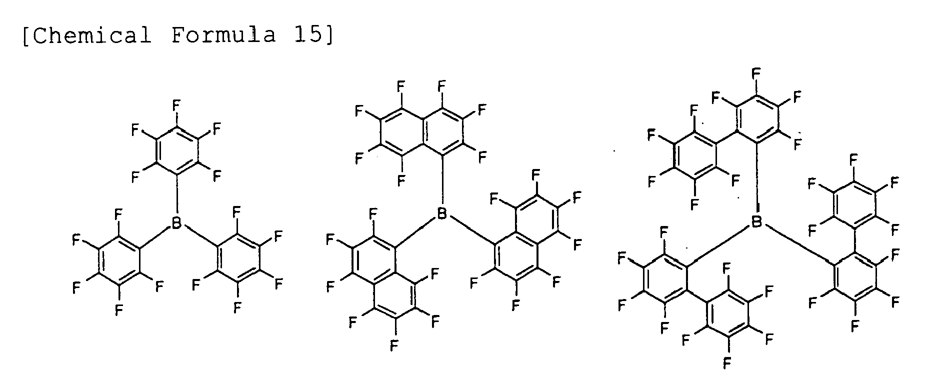

In the present invention, a metal oxide is particularly preferable among the materials capable of forming the charge transfer complex with the above-mentioned hole transporting materials by the oxidation-reduction reaction, wherein vanadium pentoxide (V₂O₅) and molybdenum trioxide (MoO₃) are more preferable.

The area containing the first hole transporting material may contain one kind of these materials or two or more kinds of the materials capable of forming the charge transfer complex with the hole transporting material by the oxidation-reduction reaction.

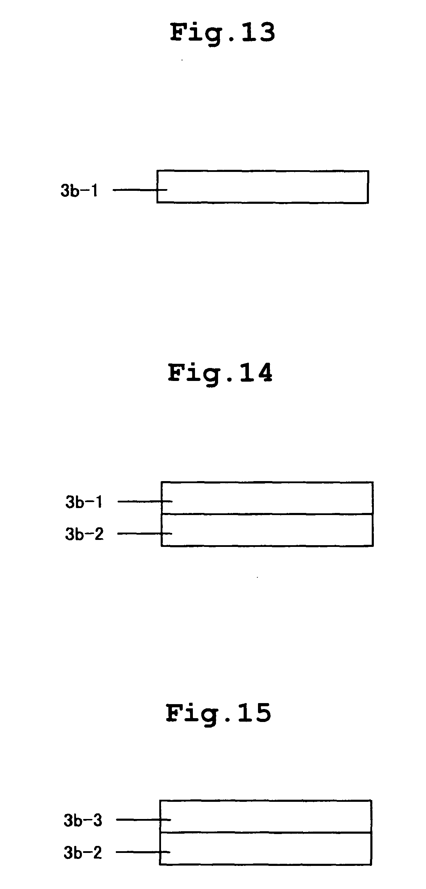

Specifically, the area containing the first hole transporting material is preferably a laminated body or mixture layer shown in FIGS. 13 to 15.

The area containing the first hole transporting material shown in FIG. 13 is a mixture layer 37 of the first hole transporting material and the material capable of forming the charge transfer complex with the first hole transporting material by the oxidation-reduction reaction (D + E).

The area containing the first hole transporting material shown in FIG. 14 is a laminated body having, laminated in this order from the anode, a layer 3b-2 containing the material (E) capable of forming the charge transfer complex with the first hole transportingmaterial by the oxidation-reduction reaction, and a mixture layer 3b-1 containing the first hole transporting material and the material capable of forming the charge transfer complex with the first hole transporting material by the oxidation-reduction reaction (D + E).

The area containing the first hole transporting material shown in FIG. 15 is a laminated body having, laminated in this order from the anode, a layer 3b-2 containing the material (E) capable of forming the charge transfer complex with the first hole transporting material by the oxidation-reduction reaction, and a layer 3b-3 containing the first hole transporting material (D) .

Each layer shown in FIGS. 13 to 15 is illustrated as a laminated body, but it is not necessary that the interface is always clearly present in each layer. The upper layer and the lower layer may be mixed in the vicinity of the interface. Alternatively, the material continuously changes from the lower layer to the upper layer with a concentration gradient.

The mixture layer 3b-1 containing the first hole transporting material and the material capable of forming the charge transfer complex with the first hole transporting material by the oxidation-reduction reaction (D + E) also functions as the hole transporting layer to the first luminescent layer.

Although the thickness serving as a part of the charge generating layer and the thickness serving as the hole transporting layer in these layers are not necessarily be distinguished clearly, the thickness serving as a part of the charge generating layer is ordinarily 1 nm or larger and 100 nm or smaller, preferably 5 nm or larger and 50 nm or smaller.

Similarly, the layer 3b-3 containing the first hole transporting material (D) shown in FIG. 15 also functions as the hole transporting layer to the first luminescent layer.

In this case, although the thickness serving as a part of the charge generating layer and the thickness serving as the hole-transporting layer in these layers are not necessarily be distinguished clearly, the thickness serving as a part of the charge generating layer is ordinarily 0.1 nm or larger and 100 nm or smaller, preferably 1 nm or larger and 50 nm or smaller.

In the laminated body shown in FIGS. 14 and 15, the thickness of the layer 3b-2 containing the material (E) capable of forming the charge transfer complex with the first hole transporting material by the oxidation-reduction reaction is ordinarily 0.1 nm or larger and 100 nm or smaller, preferably 1 nm or larger and 50 nm or smaller.

When the area containing the first hole transporting material is a mixed layer containing the first hole-transporting material and the material capable of forming the charge transfer complex with the first hole transporting material by the oxidation-reduction reaction (D + E) as shown in FIG. 13, its composition is such that the charge transfer complex is formed with the first hole transporting material by the oxidation-reduction reaction with respect to 1 mol of the first hole transporting material, wherein the composition is ordinarily 0.01 mol or more and 100 mol or less, preferably 0.1 mol or more and 10 mol or less.

### (Luminescent layer)

The organic EL device according to the present invention has the luminescent layer between the first charge generating layer and the cathode.

The luminescent layer may be a single layer or a laminated body having two or more layers. As an example of the laminated body having two layers, a luminescent layer of yellow or orange and a luminescent layer of blue are laminated, for example, whereby white luminescence is provided.

The thickness of the entire luminescent layer is ordinarily 1 nm or larger and 200 nm or smaller, preferably 20 nm or larger and 100 nm or smaller.

The luminescent layer is made of a material that efficiently recombines the holes injected from the first charge generating layer to the electrons injected from the cathode, and efficiently emits light by the recombination. Examples of the compounds satisfying the above-mentioned condition for forming the luminescent layer emitting fluorescent light include a complex compound such as aluminum complex of 8-hydroxyquinoline, a complex compound of 10-hydroxybenzo[h] quinoline, bisstyrylbenzene derivative, bisstyrylarylene derivative, complex compound of (2-hydroxyphenyl) benzothiazole, silol derivative, etc. Among the above-mentioned hole transporting materials, aromatic amine compound having fluorescence can be used as a material of the constituent of the luminescent layer.

In order to enhance the luminescent efficiency of the device and change the luminescent color, it is effective to dope a fluorescent pigment to the above-mentioned materials for the luminescent layer as a host material. For example, the complex compound such as aluminum complex of 8-hydroxyquinoline is used as a host material, and naphthacene derivative represented by rubrene, quinacridone derivative, condensed polycyclic aromatic ring such as perylene, or the like is doped to the host material in an amount of 0.1 to 10 wt.%, whereby the luminescent characteristic of the device, particularly the driving stability can significantly be enhanced.

Various fluorescent pigments other than coumarin can be used as the doped pigment. Examples of the fluorescent pigment providing blue luminescence include perylene, pyrene, anthracene, coumarin, and derivative thereof. Examples of green fluorescent pigment include quinacridone derivative, coumarin derivative, etc. Examples of the yellow fluorescent pigment include rubrene, perimidone derivative, etc. Examples of the red fluorescent pigment include DCM compound, benzopyrane derivative,rhodamine derivative,benzothioxanthene derivative, azabenzothioxanthene derivative, etc. Except for these, fluorescent pigments listed in the document ("Laser Research", 1980, Vol. 8, p. 694, 803, 958; 1981, Vol. 9, p. 85) can be used as the doped pigment for the luminescent layer depending upon the host material.

The luminescent layer can be formed as a phosphor luminescent layer from a phosphor dopant (hereinafter referred to as a phosphor pigment) and the host material.

Examples of the phosphor pigment include porphylin complex such as 2,3,7,8,12,13,17,18-octaethyl-21H, 23H-porphylin platinum (II), organic iridium complex such as tris(2-phenylpyridine) iridium, organic platinum complex such as bis(2-thienylpyridine) platinum, mixed ligand organic metal complex such as bis(2-(2'-benzothienyl)-pyridinate) iridium (acetylacetonate).

Examples of the host material in the phosphor luminescent layer include carbazole derivative such as 4,4'-N,N'-dicarbazolebiphenyl, tris(8-hydroxyquinoline) aluminum, 2,2',2"-(1,3,5-benzentolyl) tris[1-phenyl-1H-benzimidazole], polyvinylcarbozole.

Subsequently shown in FIG. 2 is another aspect of the organic EL device according to the present invention having a layer 6 containing an electron transporting material formed between the anode 2 and the first charge generating layer 3 of the organic EL device shown in FIG. 1.

The layer 6 containing the electron transporting material may be formed as described above in order to stably transport electrons generated in the first charge generating layer 3 to the anode 2.

The material same as that used for the layer containing the first electron transporting material formed at the anode side of the first charge generating layer can be used for the layer containing the electron transporting material.

The material same as the first electron transporting material or the material different from the first electron transporting material can be used. It is preferable that the material same as the first electron transporting material is used, since there is no barrier in LUMO (lowest unoccupied molecular orbit) in the transportation of electrons in the case of the same material. When the different material is used, it is preferable that the absolute value of LUMO of the material composing the layer 6 containing the electron transporting material is larger than the absolute value of LUMO of the first electron transporting material because of the reason described above.

When the material is the same as the first electron transporting material, the area containing the first electron transporting material and the layer containing the electron transporting material cannot clearly be distinguished.

The thickness of the layer containing the electron transporting material is ordinarily 200 nmor smaller, preferably 100 nm or smaller.

In this case, the layer containing the electron transporting material is preferably adjacent to the anode.

The organic EL device according to the present invention may have layers, in addition to the above-mentioned layers, applied to a conventional organic EL device between each layer.

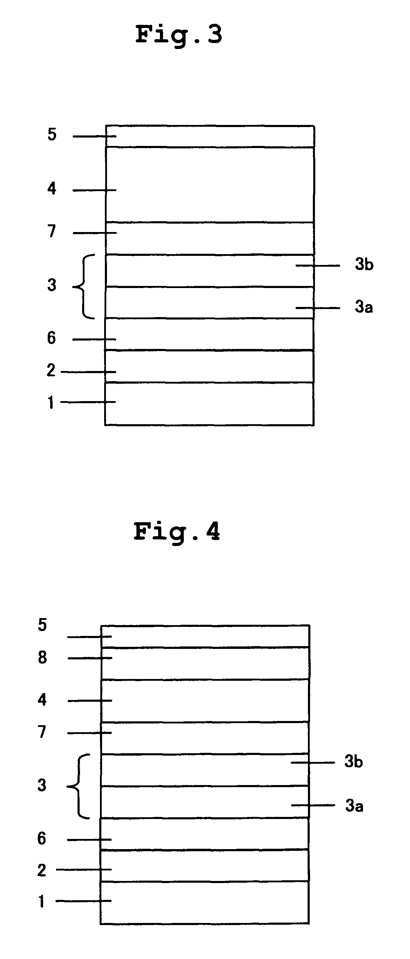

FIGS. 3 to 5 show another preferable aspects of the organic EL device according to the present invention.

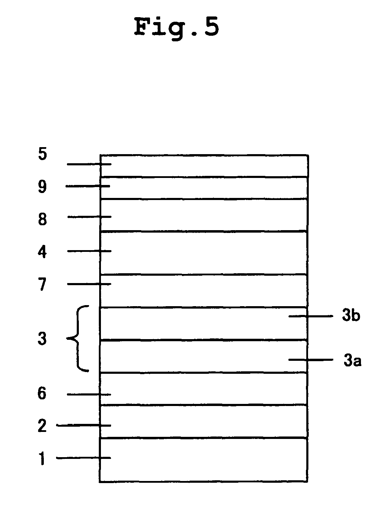

As shown in FIG. 3, a hole transporting layer 7 may be formed between the first charge generating layer 3 and the luminescent layer 4 in order to enhance the luminescent characteristic of the device. As shown in FIG. 4, an electron transporting layer 8 may be formed between the luminescent layer 4 and the cathode 5. As shown in FIG. 5, an electron injecting layer 9 may be formed between the electron transporting layer 8 and the cathode 5.

The hole transporting layer 7 is required to efficiently transport and inject holes, which are injected from the area 3b of the first charge generating layer 3 at the cathode side containing the first hole transporting material, to the luminescent layer 4. The material same as the hole transporting material used for the area 3b containing the first hole transporting material can be used as the material of the hole transporting layer 7.

The material composing the hole transporting layer 7 may be the same as the first hole transporting material or different from the first hole transporting material. The material same as the first hole transporting material is preferably used, since there is no barrier in HOMO (highest occupied molecular orbit) in the transportation of holes in the case of the same material. When the different material is used, it is preferable that the absolute value of HOMO of the material composing the hole transporting layer 7 is larger than the absolute value of HOMO of the first hole-transporting material. If the absolute value of HOMO of the luminescent layer 4 is larger than the absolute value of HOMO of the first hole transporting material, it is preferable that the hole transporting layer 7 has HOMO between the HOMO of the luminescent layer 4 and the HOMO of the first hole transporting material.

The hole transporting layer 7 may be a mixed layer of plural hole transporting materials, or may be a laminated body of plural layers containing different materials.

The thickness of the hole transporting layer 7 is ordinarily 200 nm or smaller, preferably 5 nm or larger and 100 nm or smaller.

The electron transporting layer 8 is required to efficiently transport and inject electrons, which are injected from the cathode, to the luminescent layer. The electron transporting material used for the area containing the first electron transporting material formed at the anode side of the first charge generating layer can be used as the material described above.

The material composing the electron transporting layer 8 may be the same as the first electron transporting material or different from the first electron transporting material. The electron transporting layer 8 may be a mixed layer of plural electron transporting materials or a laminated body of plural layers containing different materials.

The thickness of the electron transporting layer is ordinarily 200 nm or smaller, preferably 5 nm or larger and 100 nm or smaller.

When a short wavelength luminescent layer (e.g., blue luminescent layer) having large luminescent energy or phosphor luminescent layer is used as the luminescent layer, an area containing a material for blocking the transportation of holes may be formed as a hole blocking layer as the electron transporting layer adjacent to the luminescent layer at the cathode side. The hole blocking layer has a function of confining holes and electrons in the luminescent layer so as to enhance luminescent efficiency.

Accordingly, the hole blocking layer is preferably composed of a material that can prevent the holes moving from the hole transporting layer from passing through the luminescent layer and that can efficiently transport the electrons injected from the cathode toward the luminescent layer.

Therefore, the material composing the hole blocking layer needs high electron mobility, low hole mobility, HOMO level deeper than the luminescent layer, and difficulty of holes being injected from the luminescent layer. However, known materials can be used.

The electron injecting layer 9 requires the efficient injection of electrons from the cathode to the luminescent layer.

The effective method for enhancing efficiency of the device includes the formation of a very thin film having a thickness of 0.1 to 5 nm made of LiF or Li2O as the electron injecting layer 9. The above-mentioned structure in which the area containing the first electron transporting material is formed can be employed.

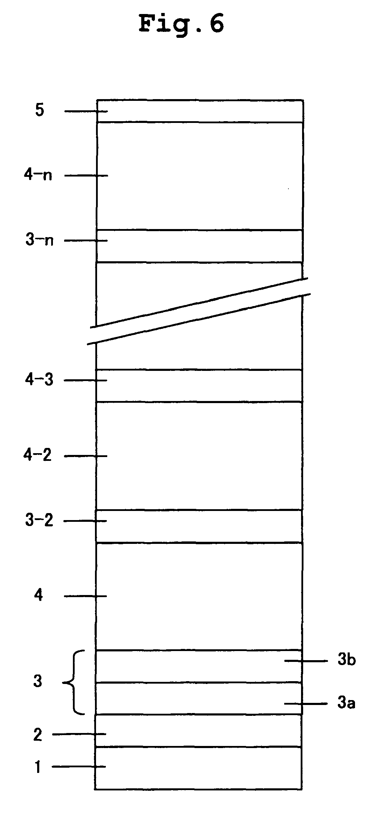

FIG. 6 shows another aspect of the organic EL device according to the present invention. The organic EL device shown in FIG. 6 has a so-called multi-photon emission (MPE) structure, wherein at least one set of a charge generating layer 3-n and a luminescent layer 4-n (n is an integer of 2 or more here) in this order is provided between the luminescent layer 4 and the cathode 5.

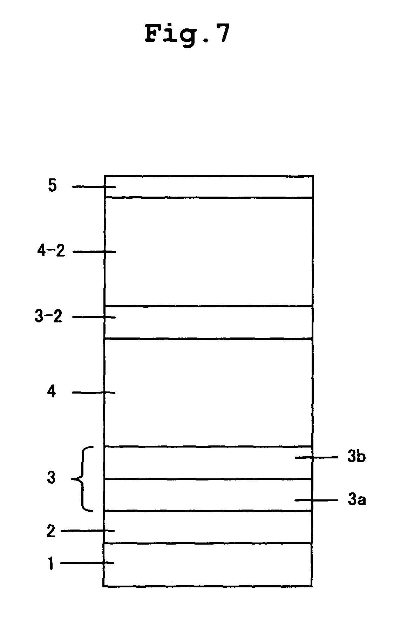

FIG. 7 shows the structure of the organic EL device having one set of the charge generating layer (second charge generating layer 3-2) and the luminescent layer (second luminescent layer 4-2) between the luminescent layer 4 and the cathode 5. The structure of the second charge generating layer may be the same or different from the first charge generating layer described above.

The material same as that of the first charge generating layer may be used. It is preferable that the material same as that of the first charge generating layer is used for the second charge generating layer.

When the second charge generating layer is made of the material different from that of the first charge generating layer, an insulating layer having a specific resistance of not less than 1.0 × 10² disclosed in JP-A No. 2003-272860 and JP-A No. 2006-24791 can be used. Inorganic materials such as vanadium pentoxide (V₂O₅), molybdenum trioxide (MoO₃), or electron-accepting compounds such as F4-TCNQ or the like is preferable. Among these, vanadium pentoxide (V₂O₅) and molybdenum trioxide (MoO₃) are more preferable.

The structure of the second luminescent layer can basically be the same as the structure of the first luminescent layer. The constituent material thereof may be the same as or different from that of the first luminescent layer, and the material is appropriately selected according to the luminescent color required as the device.

In the aspect having plural sets of the charge generating layer and the luminescent layer shown in FIGS. 6 and 7, the hole transporting layer, electron transporting layer and electron injecting layer may be provided in order to enhance luminescent characteristic of the device, like the above-mentioned organic EL device having one set of charge generating layer and luminescent layer.

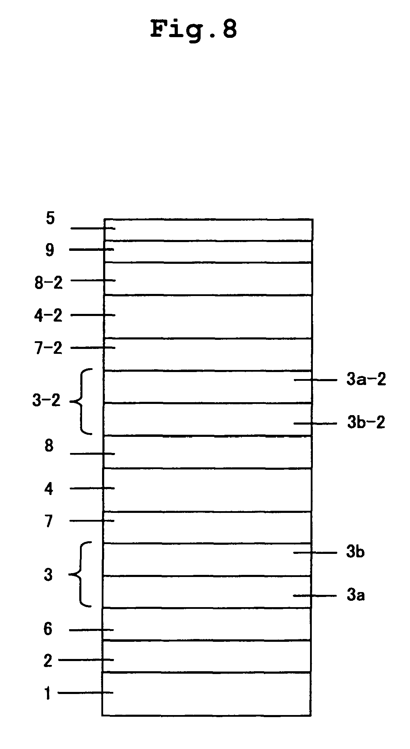

For example, FIG. 8 shows an organic EL device having a hole transporting layer 7-2 between the second charge generating layer 3-2 and the second luminescent layer 4-2, an electron transporting layer 8-2 between the second luminescent layer 4-2 and the cathode 5, and an electron injecting layer 9 between the electron transporting layer 8-2 and the cathode 5.

A top-emission device may be used as the organic EL device according to another aspect of the present invention.

Since the organic EL device according to the present invention has the area containing the electron transporting material or the electron transporting layer on the anode, the device can be formed in the manner described above by using a metal ordinarily used for a cathode such as aluminum or the like having a low work function as the anode. In this case, the cathode is formed by providing a transparent electrode, used for the aforesaid anode, by a sputtering method or vacuum deposition method.

The formation method of each layer of the organic EL device according to the present invention is not particularly limited. Each layer may be formed by a vacuum deposition method and wet film-formingmethod. In the case of the wet film-forming method, each layer is formed by using solution, which is obtained by dissolving or dispersing the material contained in the above-mentioned each layer in appropriate solvent.

The present invention will specifically be explained on the basis of the Examples, but the present invention is not limited by the Examples described below.

### [Example 1]

An organic EL device having the basic structure shown in FIG. 5 was formed according to the following method.

### (Formation of anode)

A transparent conductive film of indium tin oxide (ITO) was deposited on a glass substrate in a thickness of 110 nm to form a sputter deposition film. The resultant was patterned into a stripe having a width of 2 mm with a general photolithography and etching to form an anode.

The ITO substrate having the pattern formed thereon was subject to the cleaning process, i.e., it was subject to ultrasonic cleaning by means of pure water and surfactant, a cleaning process with running pure water, an ultrasonic cleaning by means of 1 : 1 mixed solution of pure water and isopropyl alcohol, and a boiling cleaning with isopropyl alcohol in this order. This substrate was slowly pulled from the boiling isopropyl alcohol, dried in the vapor of the isopropyl alcohol, and finally, was subject to the ultraviolet ozone cleaning.

This substrate was placed in a vacuum deposition device, and the device was evacuated to have a vacuum level of not more than 5.0 × 10⁻⁵ Pa by means of a cryopump. A deposition mask was adhered onto a predetermined area of the substrate. Necessary deposition materials were put into different boats made of molybdenum and arranged in the vacuum deposition device.

### (Formation of first charge generating layer)

The boat made of molybdenum and having the first charge transporting material (Alq₃) represented by the following (Chemical Formula 16) put therein and the boat made of molybdenum and having Liq put therein as an organic metal complex compound containing metal ions having low work function were simultaneously energized and heated so as to co-deposit the first charge transporting material and Liq on an anode ITO. The mixture layer in which Alq₃ : Liq = 3 : 1 was formed with a thickness of 10 nm under the condition such that the vacuum level upon the deposition was 3.2 × 10⁻⁵ Pa, the deposition rate of Alq₃ was 1.5 A/s, and the deposition rate of Liq was 0.5 A/s.

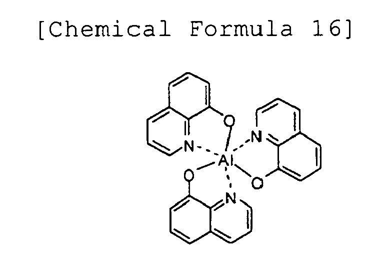

Subsequently, the boat made of tungsten and having aluminum (Al) put therein as a thermally reducible metal was energized and heated to co-deposit Al on the mixture layer of Alq₃ and Liq. The area containing the first electron transporting material was formed with a thickness of 1.5 nm under the condition such that the vacuum level upon the deposition was 3.7 × 10⁻⁵ Pa, and the deposition rate was 0.5 A/s.
Then, the boat made of molybdenum and having α-NPD put therein as a first hole transporting material and the boat made of molybdenum and having molybdenum trioxide (MoO₃) put therein as a material capable of forming a charge transfer complex with the first hole transporting material by an oxidation-reduction reaction were simultaneously energized and heated to co-deposit α-NPD and MoO₃ on the area containing the first electron transporting material. The area containing the first hole transporting material in which α-NPD : MoO₃ = 4 : 1 was formed with a thickness of 10 nm under the condition such that the vacuum level upon the deposition was 2.8 × 10⁻⁵ Pa, the deposition rate of α-NPD was 2.0 A/s, and the deposition rate of MoO₃ was 0.5 A/s.

### (Formation of hole transporting layer)

The boat made of molybdenum and having α-NPD put therein was energized and heated to co-deposit α-NPD on the first charge generating layer. The hole transporting layer was formed with a thickness of 40 nm under the condition such that the vacuum level upon the deposition was 2.8 × 10⁻⁵ Pa and the deposition rate was 2.0 A/s.

### (Formation of first luminescent layer)

The boat made of molybdenum and having Alq₃ put therein as a host material and the boat made of molybdenum and having a fluorescent organic compound (C545T), represented by the following (Chemical Formula 17), put therein as a dopant were simultaneously energized and heated to co-deposit Alq₃ and C545T on the hole transporting layer. The first luminescent layer in which Alq₃ : C545T = 100 : 1 was formed with a thickness of 30 nm under the condition such that the vacuum level upon the deposition was 2.5 × 10⁻⁵ Pa, the deposition rate of Alq₃ was 2.0 A/s, and the deposition rate of C545T was 0.2 A/s.

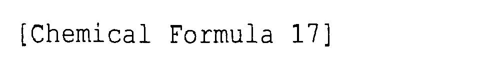

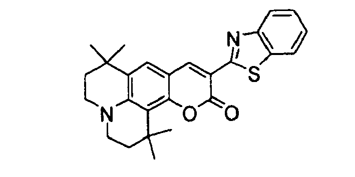

### (Formation of electron transporting layer)

The boat made of molybdenum and having Alq₃ put therein was energized and heated to co-deposit Alq₃ on the first luminescent layer. The electron transporting layer was formed with a thickness of 34 nm under the condition such that the vacuum level upon the deposition was 2.5 × 10⁻⁵ Pa and the deposition rate was 2.0 A/s.

### (Formation of electron injecting layer)

The boat made of molybdenum and having Al_{q3} put therein and the boat made of molybdenum and having Liq put therein were simultaneously energized and heated to co-deposit Alq₃ and Liq on the electron transporting layer. The electron injecting layer in which Alq₃ : Liq = 3 : 1 was formed with a thickness of 10 nm under the condition such that the vacuum level upon the deposition was 2.6 × 10⁻⁵ Pa, the deposition rate of Alq₃ was 1.5 A/s, and the deposition rate of Liq was 0.5 A/s.

### (Formation of cathode)

The mask was exchanged with the vacuum deposition device kept in vacuum, and a stripe shadow mask having a width of 2 mm was adhered as a mask for depositing the cathode onto the device so as to be orthogonal to the ITO stripe of the anode.

The boat made of molybdenum and having aluminum put therein as a cathode was energized and heated so as to deposit aluminum on the electron injecting layer. The cathode was formed with a thickness of 100 nm under the condition such that the vacuum level upon the start of the deposition was 3.1 × 10⁻⁵ Pa, the vacuum level upon the end of the deposition was 1.1 × 10⁻⁴ Pa, and the deposition rate was 5 A/s.

The vacuum deposition device was returned at atmospheric pressure, and the ITO substrate (hereinafter referred to as "deposited substrate") having the organic EL material deposited thereon as described above was once removed into the atmosphere. The removed ITO substrate was transferred into a nitrogen-substituted globe box and sealed by using a glass plate.

The glass plate used for sealing had a recessed portion whose area was larger than the deposition portion of the deposited substrate, other than the peripheral portion. An UV curing resin was applied by a dispenser onto the peripheral portion of the sealing glass that was not recessed, and then, the resultant was put into the nitrogen-substituted globe box.

Further, a moisture absorbent sheet was adhered to the recessed portion of the sealing glass plate, and the UV curing resin-applied portion was brought into close contact so as to enclose the deposition area of the deposited substrate. The resultant was removed in the atmosphere, and UV ray was irradiated thereto by an UV lamp to cure the UV curing resin.

In the manner described above, the organic EL device having a luminescent area portion with 2 mm × 2 mm was obtained.

The brief layered structure of the device is as follows: ITO / Alq₃ : Liq (10 nm, 3 : 1) / A1 (1.5 nm) / α-NPD : MoO₃ (10 nm, 4 : 1) / α-NPD (40 nm) / Alq₃ : C545T (30 nm, 100 : 1) / Alq₃ (34 nm) / Alq₃ : Liq (10 nm, 3 : 1) / A1 (100 nm).

### [Example 2]

The boat made of molybdenum and having the electron transporting material (Balq) represented by the following (Chemical Formula 18) put therein was energized and heated so as to deposit Balq on the anode ITO with a thickness of 5 nm under the condition such that the vacuum level was 1.9 × 10⁻⁵ Pa and the deposition rate was 2.0 A/s. The area containing the first electron transporting material in the Example 1 in which Alq₃ : Liq = 3 : 1 was deposited thereon with a thickness of 5 nm, not 10 nm, and the other conditions were the same as those in the Example 1 so as to form an organic EL device.

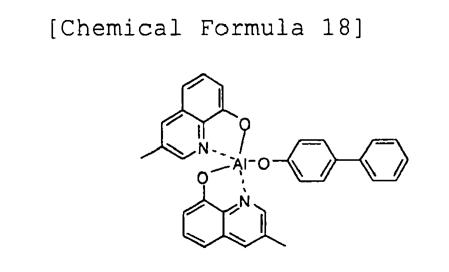

The brief layered structure of the device is as follows: ITO / Balq (5 nm) / Alq₃ : Liq (5 nm, 3 : 1) / Al (1.5 nm) / α-NPD : MoO₃ (10 nm, 4 : 1) / α-NPD (40 nm) / Alq₃ : C545T (30 nm, 100 : 1) / Alq₃ (34 nm) / Alq₃ : Liq (10 nm, 3 : 1) / A1 (100 nm).

### [Example 3]

MoO₃ was deposited between the area containing the first electron transporting material and the area containing the first hole transporting material with a thickness of 10 nm under the condition such that the vacuum level was 4.7 × 10⁻⁵ Pa and the deposition rate was 1.0 A/s. The hole transporting layer made of α-NPD was formed with a thickness of 30 nm, and the other conditions were the same as those in the Example 1, whereby an organic EL device was produced.

The brief layered structure of the device is as follows: ITO / Alq₃ : Liq (10 nm, 3 : 1) / Al (1.5 nm) / MoO₃ (10 nm) / α-NPD : MoO₃ (10 nm, 4 : 1) / α-NPD (30 nm) / Alq₃ : C545T (30 nm, 100 : 1) / Alq₃ (34 nm) / Alq₃ : Liq (10 nm, 3 : 1) / Al (100 nm).

### [Example 4]

An organic EL device was produced in the same manner as in the Example 1 except that the luminescent layer and the electron transporting layer formed thereon are formed to have the structure described below. The luminescent layer is a two-layered luminescent layer having a yellow luminescent layer and a blue luminescent layer.
The boat made of molybdenum and having α-NPD put therein as a host material and the boat made of molybdenum and having EY52 (by e-Ray Optoelectronics Technology Corporation (hereinafter referred to as e-Ray Technology Corporation)) put therein as a dopant were simultaneously energized and heated to co-deposit α-NPD and EY52 on the hole transporting layer made of α-NPD. The first luminescent layer in which α-NPD : EY52 = 100 : 1.5 was formed with a thickness of 20 nm under the condition such that the vacuum level upon the deposition was 1.5 × 10⁻⁵ Pa, the deposition rate of α-NPD was 2.0 A/s, and the deposition rate of EY52 was 0.3 A/s.
Then, the boat made of molybdenum and having EB43 (by e-Ray Corporation) put therein as a host material and the boat made of molybdenum and having EB52 (by e-Ray Corporation) put therein as a dopant were simultaneously energized and heated to co-deposit EB43 and EB52 on the first luminescent layer. The second luminescent layer in which EB43 : EB52 = 100 : 1.0 was formed with a thickness of 30 nm under the condition such that the vacuum level upon the deposition was 1.6 × 10⁻⁵ Pa, the deposition rate of EB43 was 2.0 A/s, and the deposition rate of EB52 was 0.2 A/s.

The electron transporting layer with a thickness of 23 nm was formed by depositing Alq₃ in the same manner as in the Example 1.

The brief layered structure of the device is as follows: ITO / Alq₃ : Liq (10 nm, 3 : 1) / Al (1.5 nm) / α-NPD : MoO₃ (10 nm, 4 : 1) / α-NPD (40 nm) / α-NPD : EY52 (20 nm, 100 : 1.5) / EB43 : EB52 (30 nm, 100 : 1.0) / Alq₃ (23 nm) / Alq₃ : Liq (10 nm, 3 : 1) / Al (100 nm).

### (Example 5)

A second charge generating layer and a second luminescent layer ware formed with the structures same as those of the first charge generating layer and the first luminescent layer in the Example 1, whereby a two-layered organic EL device having two sets of the charge generating layer and the luminescent layer was formed.

In the same manner as in the Example 1, the first charge generating layer, hole transporting layer, first luminescent layer, and electron transporting layer were formed on the anode of ITO in this order. The same-layered structure was repeated thereon so as to form the second charge generating layer, hole transporting layer, second luminescent layer, and electron transporting layer. Further, the electron injecting layer and cathode were formed thereon.

The thickness of the hole transporting layer formed between the first charge generating layer and the first luminescent layer was set to 30 nm, and the thickness of the hole transporting layer formed between the second charge generating layer and the second luminescent layer was set to 61 nm.

The brief layered structure of the device is as follows: ITO / Alq₃ : Liq (10 nm, 3 : 1) / Al (1.5 nm) / α-NPD : MoO₃ (10 nm, 4 : 1) / α-NPD (30 nm) / Alq₃ : C545T (30 nm, 100 : 1) / Alq₃ (34 nm) / Alq₃ : Liq (10 nm, 3 : 1) / Al (1.5 nm) / α-NPD : MoO₃ (10 nm, 4 : 1) / α-NPD (61 nm) / Alq₃ : C545T (30 nm, 100 : 1) / Alq₃ (34 nm) / Alq₃ : Liq (10 nm, 3 : 1) Al (100 nm).

### [Comparative Example 1]

An organic EL device was formed in the same manner as in the Example 1 except that the area containing the first electron transporting material was not formed and the thickness of the α-NPD in the hole transporting layer was set to 50 nm.

The brief layered structure of the device is as follows: ITO / α-NPD : MoO₃ (10 nm, 4 : 1) / α-NPD (50 nm) / Alq₃ : C545T (30 nm, 100 : 1) / Alq₃ (34 nm) / Alq₃ : Liq (10 nm, 3 : 1) / Al (100 nm).

This device was evaluated, like the Example 1, when it was driven with constant current.

Table 1 shows the results.

### [Comparative Example 2]

An organic EL device was formed in the same manner as in the Example 3 except that the area containing the first electron transporting material was not formed and the thickness of the α-NPD in the hole transporting layer was set to 40 nm.

The brief layered structure of the device is as follows: ITO / MoO₃ (10 nm) / α-NPD : MoO₃ (10 nm, 4 : 1) / α-NPD (40 nm) / Alq₃ : C545T (30 nm, 100 : 1) / Alq₃ (34 nm) / Alq₃ : Liq (10 nm, 3 : 1) / Al (100 nm).

### [Comparative Example 3]

An organic EL device was formed in the same manner as in the Example 4 except that the area containing the first electron transporting material was not formed and the thickness of the α-NPD in the hole transporting layer was set to 50 nm.

The brief layered structure of the device is as follows: ITO / α-NPD : MoO₃ (10 nm, 4 : 1) / α-NPD (50 nm) / α-NPD : EY52 (20 nm, 100 : 1.5) / EB43 : EB52 (30 nm, 100 : 1.0) / Alq₃ (23 nm) / Alq₃ : Liq (10 nm, 3 : 1) / Al (100 nm).

### [Comparative Example 4]

An organic EL device was formed in the same manner as in the Example 5 except that the area containing the first electron transporting material was not formed and the thickness of the α-NPD in the hole transporting layer was set to 40 nm.

The brief layered structure of the device is as follows: ITO / α-NPD : MoO₃ (10 nm, 4 : 1) / α-NPD (40 nm) / Alq₃ : C545T (30 nm, 100 : 1) / Alq₃ (34 nm) / Alq₃ : Liq (10 nm, 3 : 1) / Al (1.5 nm) / α-NPD : MoO₃ (10 nm, 4 : 1) / α-NPD (61 nm) / Alq₃ : C545T (30 nm, 100 : 1) / Alq₃ (34 nm) / Alq₃ : Liq (10 nm, 3 : 1) Al (100 nm).

Table 1 shows the layer-structure of the Examples and Comparative Examples.

**[Table 1]**

| THICKNESS UNIT : nm | MATERIAL | EXAMPLE | | | | | COMPARATIVE EXAMPLE | | | |
|---|---|---|---|---|---|---|---|---|---|---|
| | | 1 | 2 | 3 | 4 | 5 | 1 | 2 | 3 | 4 |
| ANODE | ITO | 110 | 110 | 110 | 110 | 110 | 110 | 110 | 110 | 110 |
| AREA CONTAINING ELECTRON TRANSPORTING MATERIAL | BAlq | - | 5 | - | - | - | - | - | - | - |
| FIRST CHARGE GENERATING LAYER | Alq₃: Liq (75:25) | 10 | 5 | 10 | 10 | 10 | - | - | - | - |
| | Al | 1.5 | 1.5 | 1.5 | 1.5 | 1.5 | - | - | - | - |
| | MoO₃ | - | - | 10 | - | - | - | 10 | - | - |
| | NPD:MoO₃ (80:20) | 10 | 10 | 10 | 10 | 10 | 10 | 10 | 10 | 10 |
| HOLE TRANSPORTING LAYER | NPD | 40 | 40 | 30 | 40 | 30 | 50 | 40 | 50 | 40 |
| FIRST LUMINESCENT LAYER | Alq₃:C545T (100:1) | 30 | 30 | 30 | - | 30 | 30 | 30 | - | 30 |
| | NPD:EY52 (100:1.5) | - | - | - | 20 | - | - | - | 20 | - |
| | EB43:EB52 (100:1.0) | - | - | - | 30 | - | - | - | 30 | - |
| ELECTRON TRANSPORTING LAYER | Alq₃ | 34 | 34 | 34 | 23 | 34 | 34 | 34 | 23 | 34 |
| ELECTRON INJECTING LAYER | Alq₃: Liq (75:25) | 10 | 10 | 10 | 10 | - | 10 | 10 | 10 | - |
| SECOND CHARGE GENERATING LAYER | Alq₃:Liq (75:25) | - | - | - | - | 10 | - | - | - | 10 |
| | A1 | - | - | - | - | 1.5 | - | - | - | 1.5 |
| | NPD:MoO₃ (80:20) | - | - | - | - | 10 | - | - | - | 10 |
| HOLE TRANSPORTING LAYER | NPD | - | - | - | - | 61 | - | - | - | 61 |
| SECOND LUMINESCENT LAYER | Alq₃:C545T (100:1) | - | - | - | - | 30 | - | - | - | 30 |
| ELECTRON TRANSPORTING LAYER | Alq₃ | - | - | - | - | 34 | - | - | - | 34 |
| ELECTRON INJECTING LAYER | Alq₃:Liq (75:25) | - | - | - | - | 10 | - | - | - | 10 |
| CATHODE | A1 | 100 | 100 | 100 | 100 | 100 | 100 | 100 | 100 | 100 |

### (Evaluation of driving life of device)

The organic EL devices produced in the Examples and Comparative Examples were evaluated for the time taken for reducing the initial luminance, initial voltage and relative luminance to 70% and the change in the voltage at that time, and the relative luminance and the change in the voltage after the lapse of 500 hours, when the devices were driven with constant current at 22°C at 20 mA/cm².

Table 2 shows the results.

**[Table 2]**

| | AT START OF DRIVING | | AT 80% RELATIVE LUMINANCE | | AFTER LAPSE OF 500hr | |
|---|---|---|---|---|---|---|
| | LUMINANCE (cd/m²) | VOLTAGE (V) | TIME (hr) | VOLTAGE RISE (V) | RELATIVE LUMINANCE (%) | VOLTAGE RISE (V) |
| EXAMPLE 1 | 2760 | 8.1 | 340 | 0.8 | 75 | 0.8 |
| EXAMPLE 2 | 2500 | 9.9 | 500 | 0.6 | 80 | 0.6 |
| EXAMPLE 3 | 2740 | 8.0 | 430 | 1.3 | 78 | 1.3 |
| EXAMPLE 4 | 1330 | 9.2 | 4000 | 1.2 | 93 | 0.9 |
| EXAMPLE 5 | 5670 | 15.4 | 420 | 2.1 | 77 | 2.1 |
| COMPARATIVE EXAMPLE 1 | 2680 | 6.5 | 32 | 0.6 | 45 | 1.5 |
| COMPARATIVE EXAMPLE 2 | 2770 | 6.2 | 81 | 0.5 | 53 | 1.1 |
| COMPARATIVE EXAMPLE 3 | 1340 | 6.6 | 94 | 0.6 | 63 | 1.0 |
| COMPARATIVE EXAMPLE 4 | 6140 | 13.0 | 37 | 1.0 | 53 | 3.1 |

From the results of the evaluation shown in Table 2, it was confirmed that the driving life was increased according to the organic EL devices in the Examples 1 to 5, whereby the organic EL devices were stably driven for a long time.

## Claims

1. An organic electroluminescent device including, in this order, an anode, a charge generating layer, a luminescent layer, and a cathode, wherein
the charge generating layer has an area containing an electron transporting material at the anode side, and has an area containing a hole transporting material and a material that is capable of forming a charge transfer complex by an oxidation-reduction reaction with the hole transporting material, these materials being laminated or mixed, and the hole transporting material is in a radical cation state.

2. An organic electroluminescent device according to claim 1, wherein
the area containing the electron transporting material comes in contact with the anode.

3. An organic electroluminescent device according to claim 1, further comprising:
a layer containing an electron transporting material formed between the anode and the charge generating layer.

4. An organic electroluminescent device according to claim 1, wherein
the layer containing the electron transporting material comes in contact with the anode.

5. An organic electroluminescent device according to claim 1, wherein
at least one set including at least a charge generating layer and a luminescent layer in this order is formed between the luminescent layer and the cathode.

6. An organic electroluminescent device according to claim 5, wherein
at least one layer of the charge generating layers composing the sets has an area containing an electron transporting material at the anode side, and has an area containing a hole transporting material and a material that is capable of forming a charge transfer complex by an oxidation-reduction reaction with the hole transporting material, these materials being laminated or mixed, and the hole transporting material is in a radical cation state.

7. An organic electroluminescent device according to claim 1, wherein
the material capable of forming the charge transfer complex by an oxidation-reduction reaction with the hole transporting material is a metal oxide.
